# NEW EUROPEAN PATENT SPECIFICATION

(11) **EP 0 330 679 B2**
(45) Date of publication and mention of the opposition decision: **02.04.1997**
(45) Mention of the grant of the patent: 27.01.1993
(21) Application number: 88903651.3
(22) Date of filing: 25.03.1988
(51) Int. Cl.: C04B 35/58, B05D 7/00, C23C 16/00

(54) **SIALON CUTTING TOOL COMPOSITION**
SIALONVERBINDUNG FÜR SCHNEIDWERKZEUGE
COMPOSITION A BASE DE SIALON POUR OUTIL DE COUPE

(30) Priority: 19.05.1987 US 51964
(43) Date of publication of application: 06.09.1989
(73) Proprietor: KENNAMETAL INC., Latrobe, PA 15650 (US)
(72) Inventor: MEHROTRA, Pankaj, Kumar, Greensburg, PA 15601 (US); SWIOKLA, Joyce, L., Export, PA 15632-9746 (US)
(74) Representative: Leiser, Gottfried, Dipl.-Ing.
(86) International application number: US8800994
(87) International publication number: WO8809315

(56) References cited:
- EP-A- 0 298 936
- DE-C-13 509 572
- FR-A- 2 339 584
- GB-A- 2 157 282
- JP-A-58 145 676
- US-A- 4 424 066
- US-A- 4 469 489
- US-A- 4 539 251
- US-A- 4 629 661

## Description

The invention relates to a sialon ceramic material comprising a ceramic core selected from α'-sialon, β'-sialon and an intergranular phase, including a glass phase.

Materials for cutting tool inserts fall into several well-known categories. These include high speed steels, cast alloys of cobalt and chromium, sintered carbides and ceramic materials. Each type of material has an advantage depending upon the application. Ceramic materials are used in especially difficult applications. They have high hardness, chemical inertness and wear resistance even at elevated temperatures. However, ceramic cutting tools are often deficient in toughness.

There has been a growing interest in the use of ceramic materials known in the art as sialons as materials for cutting tools. Sialons are compositions of silicon, aluminum, oxygen and nitrogen and sometimes other elements. Several sialon phases are recognized including alpha-prime-sialon and beta-prime-sialon. Cutting tools may be made from either alpha-prime-sialons, beta-prime-sialons or mixtures thereof. As with many ceramic compositions, sialons often comprise an intergranular phase. For a description of a beta-prime-sialon material, reference is made to United States Patent No. 4,127,416. For a complete description of mixed alpha-prime-sialon/beta-prime-sialon compositions useful for cutting tool inserts, reference is made to United States Patent Nos. 4,563,431 and 4,547,470.

One advantage of sialon ceramic cutting tool inserts is increased toughness. For a ceramic material, sialons have exceptional toughness. Sialons have higher hot hardness and elevated temperature compressive strength than cemented carbides. This should allow sialons to resist thermal deformation and flank wear during machining better than cemented carbides. A disadvantage of sialon cutting tool inserts is that they have less than desired chemical resistance. Under the conditions of high speed steel roughing, both sialons and cemented carbides will quickly fail by crater wear due to the affinity between these materials and hot steel chips.

It has been suggested that sialon cutting tools be provided with a chemical and abrasion resistant coating applied by chemical vapor deposition. For example, in United States Patent No. 4,539,251, it was taught to provide sialon compositions with a coating of a carbide of Ti, Zr, or Hf, nitride thereof, carbo-nitride thereof, carbo-oxide thereof, and carbo-nitro-oxide thereof. It is further taught in this patent and in US-A- 4,469,489 that an alumina coating may be placed over the above described coating, but no suggestion is made to place the alumina coating directly upon the sialon.

It has also been suggested by FR-A-2,339,584, which apparently corresponds to U. S. Patent No. 4,038,092, that an alumina coating may be placed directly on a reaction sintered silicon nitride substrate and then heat treated in the presence of SiO to increase the strengt of the body by forming a surface layer of beta sialon. There is, however, no suggestion of applying alumina directly to a sialon substrate containing an intergranular glass phase.

Applicants have attempted to place an alumina coating directly upon sialon compositions by chemical vapor deposition in order to significantly retard the chemical reaction with the hot steel chips. However, two problems were discovered that made the use of an alumina coating applied by chemical vapor deposition impractical. Devitrification of the intergranular glass phase occured producing a B-phase (Y₂SiAlO₅N) which results in a substantially lower toughness of the substrate. Also, the intergranular phase near the surface escaped, leaving porosity behind in about a 10 µm thick surface layer adjacent to the coatings. The degradation in the substrate properties resulted in a tendency for edge chipping and fracture during metal cutting, although flank wear and crater wear resistances were better than coated cemented carbide tool inserts tested under the same conditions.

The problem of degradation during chemical vapor deposition is related at least in part to the temperature of the substrate during the process. The applicants have determined that simply heating sialon ceramic materials (either the beta-prime-sialon type or the alpha-prime-sialon/beta-prime-sialon type) to 1000°C for the period of time it normally takes to deposit an alumina coating results in a drop in fracture toughness.

In seeking ways to restore the toughness of alumina coated sialon cutting inserts, applicants have discovered a surface alloyed sialon material that has the toughness of virgin sialon and substantially improved chemical and wear resistance.

It is an object of this invention to provide a method of surface alloying a sialon composition to provide a sialon layer at the surface with an increased aluminum and oxygen content.

It is a further object of the herein described invention to provide a sialon ceramic cutting tool insert that has excellent fracture toughness and improved chemical inertness.

The sialon ceramic material of the present invention comprises a ceramic core consisting essentially of α'-sialon and/or β'-sialon, and an intergranular phase, including a glass phase, and has an alloyed surface layer with a substantially increased aluminum and oxygen content as compared with the core composition, with a value of Z = 0.03 for β'-sialon being disclaimed.

The said sialon ceramic material is preferably used as a cutting tool insert.

Furthermore, according to this invention, there is provided a method of alloying the surface of sialon materials to increase the Z value of the beta-prime-sialons near the surface comprising the steps of (a) preparing a sialon core composition which consists essentially of β'-sialon and 0.1 to 10 volume percent intergranular phase, including a glass phase; (b) applying a coating of alumina to the surface of the core composition in a thickness of about 1 to 10 µm by chemical vapor deposition; and (c) heat treating the coated composition at temperatures up to 1750°C and for times until at least a portion of the oxygen and aluminum of the alumina coating diffuses into the surface of the core composition. Preferably, at least one-half of the volume of the alumina coating diffuses into the surface of the core composition. The sialon core composition consists essentially of alpha-prime-sialon and/or beta-prime-sialon, and an intergranular phase, including a glass phase and, optionally, substantially inert refractory phases. The refractory phases are selected from the group consisting of refractory oxides, carbides, and nitrides of metals, and mixtures, compounds and solid solutions thereof. Preferably, the chemical vapor deposition of the alumina coating is made at temperatures between 800 and 1100 °C, and most preferably, the chemical vapor deposition of the alumina coating is made at temperatures between 950 and 1050 °C. The thickness of the alumina coating applied by chemical vapor deposition is between 1 and 10 µm, preferably 5 to 7 µm. Preferably, the heat treatment is carried out in a non-oxidizing atmosphere.

The heat treating conditions suitable for preparing materials according to this invention are set forth in the following table:

| Condition | Useful Range | Preferred Range |
|---|---|---|
| Temperature | 1300-1800°C | 1500-1700°C |
| Pressure | up to 207 MPa (30 ksi) | up to 207 MPa (30 ksi) |
| Time | 15 min. to 5 hours | about 1 hour |
| Atmosphere | N₂, Ar, He | N₂ |

Where pressure is applied, it is preferably applied by hot isostatic pressing. The times and temperatures are, of course, related to each other and furnace load. The higher the temperature, the shorter the time required. The larger the furnace load, the longer the time. The precise heat treating conditions are those that will permit the aluminum and oxygen in the alumina coating to diffuse into the sialon surface and to recover the loss of toughness that takes place during the chemical vapor deposition process. In one embodiment, the times and temperatures are selected to cause only a portion of the aluminum and oxygen to diffuse into the sialon workpiece leaving a portion of the alumina on the surface as alpha alumina. With heat treating at lower temperatures and shorter times, it is more likely alumina will be left upon the surface after heat treatment. With even lower temperatures and/or even shorter times, the thickness of the alumina coating will increase.

According to one specific embodiment, the core composition consists essentially of a matrix of beta-prime-sialon and 0.1 to 10 volume percent intergranular phase. According to yet another specific embodiment, the core composition consists essentially of a matrix of up to 70 volume percent alpha-prime-sialon, 10 to 99.9 volume percent beta-prime-sialon and up to 10 percent of an intergranular phase. A variation of these embodiments would be similar compositions having a substantially inert refractory phase distributed in the matrix. According to still yet another specific embodiment, the sialons in the core composition have a volume ratio of alpha-prime-sialon to beta-prime-sialon between 5:95 and 95:5.

Generally, the intergranular phase will comprise a glassy or crystalline phase from the group YAG, N-YAM, Y-N-alpha-wollastonite, B-phase, N-apatite, N-melilite and glass.

The substantially inert refractory phases may comprise phases such as titanium nitride which are dispersed within the sialon matrix of the core composition. During manufacture of the core, they are mixed with the sialon forming ingredients as a fine powder. The substantially inert refractory phase may be present in amounts up to 80 volume percent. The refractory phases are called substantially inert because there is little reaction between them and the sialon matrix phase.

In addition to the method, there is provided according to this invention, a new sialon ceramic material useful, for example, for cutting tools, comprising a ceramic core consisting essentially of alpha-prime-sialon and/or beta-prime-sialon, and an intergranular phase including a glass phase and, optionally, substantially inert refractory phases, said sialon ceramic material having an alloyed surface layer having a substantially increased aluminum and oxygen content as compared with the core composition. The beta-prime-sialon phase in the core comprises a lower Z sialon than the beta-prime-sialon phase in the alloyed surface layer. Preferably, the alloyed surface layer is approximately 2 to 10 µm thick. Most preferably, the porosity of the surface layer is equal to the porosity of the core. It is especially preferred that a small amount of alumina remain upon the surface of the material or cutting tools.

In a specific preferred embodiment, the beta-prime-sialon phase of the core material has a Z value greater than 0 and less than or equal to 2 and the beta-prime-sialon phase of the alloyed surface layer has a Z value greater than that of the core material and less than or equal to 4. The Z value of a beta-prime-sialon is defined by the following formula: Si_{6-Z}Al_{Z}O_{Z}N_{8-Z}.

According to a special embodiment of this invention, a method is provided for alloying the surface of the sialon workpieces to increase the aluminum and oxygen content and for providing an outer coating over the alloyed surface comprising a refractory coating composition being carbides, nitrides, carbo-nitrides, oxides or mixtures thereof of vanadium, titanium, tantalum, niobium, hafnium or zirconium. This method comprises first applying an alumina coating to the surface of the sialon core composition by chemical vapor deposition and then applying the refractory coating composition by chemical vapor deposition over the alumina coating. The heat treatment step is controlled so that at least a substantial portion of the aluminum and oxygen of the alumina coating diffuses into the core composition but heat treatment is discontinued while at least a portion of the outer refractory coating retains its chemical integrity. Specifically, if the outer refractory coating is titanium nitride, then the heat treatment is preferably discontinued while a small layer of alumina may be found between the alloyed surface of the core composition and the titanium nitride coating. This special embodiment results in a new sialon ceramic material comprising a sialon ceramic core having an alloyed layer of higher aluminum and oxygen content and an adjacent refractory surface layer or coating which comprises carbides, nitrides, carbonitrides, oxides or mixtures of vanadium, titanium, tantalum, niobium, hafnium or zirconium.

Further features and other objects and advantages will become clear from the following description made with reference to the drawings in which:

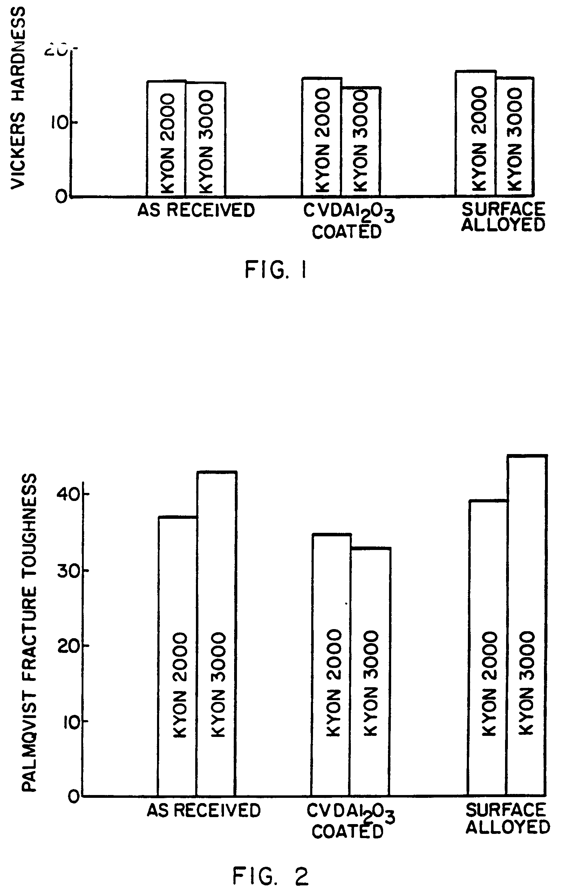

Fig. 1 is a bar graph comparing Vickers hardness (18.5 kg load) (GPa) of an alpha-prime-sialon/beta-prime-sialon cutting tool composition (KYON 2000)¹and a beta-prime-sialon cutting tool composition (KYON 3000) as received, after application of an alumina coating by chemical vapor deposition and after surface alloying according to this invention.
Fig. 2 is a bar graph comparing the Palmqvist fracture toughness, (18.5 kg load) (kg/mm) of the sialon compositions referred to in Fig. 1 as received, after application of an alumina coating and after surface alloying.

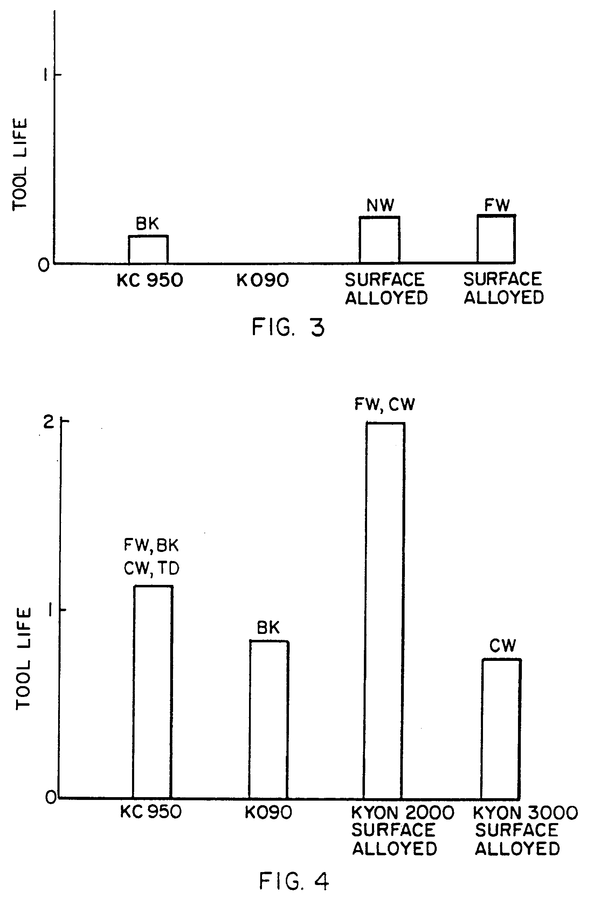

Fig. 3 is a bar graph comparing tool-lives (minutes) and failure modes of a cemented carbide (KC950 Kennametal Grade), a two-phase ceramic composition comprising alumina and titanium carbide (K090 Kennametal Grade) and two surface alloyed sialon compositions according to this invention; specifically, an alpha-prime-sialon/beta-prime-sialon composition (KYON 2000) and a beta-prime-sialon composition (KYON 3000) in high speed roughing of low alloy steel (4340).
Fig. 4 is a bar graph comparing tool-lives (minutes) and failure modes of a cemented carbide (KC950), a two-phase ceramic composition comprising alumina and titanium carbide (K090) and two surface alloyed sialon compositions according to this invention; specifically, an alpha-prime-sialon/beta-prime-sialon composition (KYON 2000) and a beta-prime-sialon composition (KYON 3000) in high speed roughing of medium carbon steel (1045).

¹KYON is a trademark of Kennametal Inc. for ceramic compositions.

### EXAMPLES I AND II

Specimens of a commercially available alpha-prime-sialon/beta-prime-sialon composition previously used for cutting tool applications (KYON 2000) and specimens of another commercially available beta-prime-sialon material also previously used for cutting tool applications (KYON 3000) were coated by chemical vapor deposition at 950 °C for a time long enough to build up an alumina coating between 5 and 7 µm thick. The specimens had previously been manufactured by known processes, for example, as set forth in United States Patent Nos. 4,563,433 and 3,991,166. (The coatings for the examples being described were applied to previously sintered and densified specimens; however, applicants contemplate that the coatings could be applied to specimens that have been sintered but not yet fully densified by hot isostatic pressing. Where the specimens have to be densified by uniaxial hot pressing in graphite molds, the coating normally would follow the densification by hot pressing and shaping by grinding.) The coated specimens were then heat treated at 1750 °C in helium at 183 MPa (20 ksi). The heat treatment (in this case by hot isostatic pressing) resulted in significant interdiffusion between the alumina coating and the substrate or core specimen.

Properties of the specimens of Example I (KYON 2000) and Example II (KYON 3000) as received, with a 6 µm alumina coating and with surface alloying according to this invention are set forth in Tables 1 and 2, respectively.

**TABLE 1**

| PROPERTY | EXAMPLE I | | |
|---|---|---|---|
| | AS RECEIVED | COATED | HEAT TREATED |
| Density (g/cm³): | 3.269 | 3.277 | 3.275 |

| Vickers | | | |
|---|---|---|---|
| Hardness - 18.5 kg (GPa): | 15.50±.22 | 15.67±.24 | 15.84±.20 |
| Fracture Toughness -Palmqvist | 18.5 kg | | |
| W (kg/mm): | 37.17±.99 | 35.11±2.06 | 39.08±.39 |
| K_{1C-} (MPam^{½})²: | 6.51±.11 | 6.62±.25 | 6.72±.04 |
| X-ray Diffraction: of core | β', α',* | β', α',* | β', α', * |

| | | | |
|---|---|---|---|
| * = Very low N-Apatite or N-YAM | | | |
| ²K_{1C} was determined in accordance with Evans and Charles, "Fracture Toughness Determinations by Indentation," J.Am. Ceramic Society, Vol. 59, No. 7-8, P. 731. | | | |

**TABLE 2**

| PROPERTY | EXAMPLE II | | |
|---|---|---|---|
| | AS RECEIVED | COATED | HEAT TREATED |
| Density (g/cm³): | 3.248 | 3.183 | 3.213 |

| Vickers | | | |
|---|---|---|---|
| Hardness - 18.5 kg (GPa): | 14,75±.18 | 14.23±.36 | 14.76±.13 |
| Fracture Toughness -Palmqvist | 18.5 kg | | |
| W (kg/mm): | 42.91±.54 | 32.81±2.93 | 44.95±2.63 |
| K_{1C-} (MPam^{½}): | 7.02±.04 | 5.96±.38 | 7.16±.17 |
| X-ray Diffraction: of core | β', B | β', B | β' |

| | | | |
|---|---|---|---|
| B = B-phase | | | |

Selected data from Tables 1 and 2 are set forth in Figs. 1 and 2. With reference to Fig. 1, it can be seen that hardness of the substrate is only slightly affected by a chemical vapor deposition coating and is somewhat improved by surface alloying, i.e., coating followed by hot isostatic pressing. With reference to Fig. 2, it is quite clear that coating alone has a pronounced detrimental effect on fracture toughness, but that surface alloying measurably improves fracture toughness. Fracture toughness of KYON 3000 appears to be much more sensitive to the coating and hot isostatic pressing treatments compared to KYON 2000.

X-ray diffraction data on the surface alloyed samples showed no distinct alumina phase and no new phases as compared with the as-received sialon materials. The B-phase was not detected in the KYON 3000 after the hot isostatic pressing.

### Metal Cutting Tests

High speed steel roughing is the intended application of coated sialon tool inserts. Metal cutting tests were conducted on Examples I and II under the following conditions representing high speed steel roughing applications:

| | |
|---|---|
| Workpieces: | 1045 Steel |
| | 4340 Steel |
| Speed: | 5.08 m/s (1000 surface feet per minute (sfm)) |
| Feed: | 0.635 mm (0.025 inches)per revolution |
| Depth of Cut: | 3.8 mm (0.15 inch) |
| Insert style: | SNG - 433 |

1045 is a medium carbon steel and 4340 is a low alloy steel.

The results of the metal cutting tests for Examples I and II are shown in Figs. 3 and 4. These are bar graphs wherein tool-life in minutes is reported along with the failure mode: NW = nose wear failure; FW = flank wear failure; CW = crater wear failure; BK = breakage failure and TD = thermal deformation failure. The surface alloyed sialon cutting tools were compared with a commercial cemented carbide tool (KC950) in a test with the low alloy steel. As shown in Fig. 3, both of the surface coated sialons have superior tool life, the sialon tools failing in the more predictable wear modes. The surface alloyed sialon cutting tools were compared to commercial cemented carbide tools (KC950) and commercial ceramic tools (K090) in a test with medium carbon steel. The surface alloyed alpha-prime-sialon/beta-prime-sialon (KYON 2000) had decidedly superior service life failing in the more predictable wear modes. The beta-prime-sialon (KYON 3000) had adequate tool life compared to the cemented carbide and ceramic tools but certainly not as long. Failure, however was in the more predictable wear mode.

Stated another way, the surface alloyed KYON 2000 tool had almost twice the tool life of the cemented carbide tool with both steels.

### EXAMPLES III-VII

A number of variations of Example I were investigated. In Example I and all the variations discussed in this section, the time at temperature during the heat treatment was one hour. Example III was similar to Example I except that the heat treatment was at 1100 °C at 138 MPa (20 ksi) argon atmosphere (hot isostatic pressure). Example IV was similar to Example I except the heat treatment was 1600 °C at 103 kPa) (15 psi) (atmospheric pressure) in an argon atmosphere. Example V was similar to Example I except that the heat treatment was at 1600 °C at 138 MPa (20 ksi) nitrogen atmosphere (hot isostatic pressure). Example VI was similar to Example I except that the heat treatment was at 1750 °C at 138 MPa (20 ksi) nitrogen atmosphere (hot isostatic pressure). Example VII was similar to Example I except that heat treatment was at 1600 °C at 103 kPa (15 psi) nitrogen (atmospheric pressure). The variation in hardness, toughness and surface composition for Examples III to VII are set forth in the following Table 3.

**TABLE 3**

| EXAMPLE | VICKERS HARDNESS 18.5kg(GPa) | PALMQVIST TOUGHNESS 18.5kgW(kg/mm) | X-RAY DIFFRACTION OF SURFACE |
|---|---|---|---|
| KYON 2000 | 15.50 | 37.17 | beta prime, alpha prime |
| KY0N 2000 (as coated) | 15.67 | 35.11 | alumina, beta prime, alpha prime |
| III | 13.72 | 24.12 | beta prime, alumina, B-, phase, alpha prime, N-YAM |
| IV | 16.11 | 35.22 | beta prime, alumina, alpha prime, N-melilite |
| V | 16.06 | 37.55 | beta prime, alumina, alpha prime |
| VI | 16.10 | 37.27 | beta prime, alpha prime |
| VII | 16.11 | 34.66 | beta prime, alumina, alpha prime, N-melilite |

Example III shows that insufficient heat treatment (1100 °C) resulted in reduced hardness and toughness. Comparing Examples V and VII shows that hot isostatic pressing can result in improved toughness over heat treatment at atmospheric pressure at the same treatment temperatures. Comparison of Examples V and VI shows that increase in heat treating temperature can result in complete diffusion of the aluminum and oxygen of the alumina into the sialon surface leaving only the beta-prime-sialon and alpha-prime-sialon phases.

### EXAMPLES VIII-IX

Examples VIII and IX were similar to Example I except that following the chemical vapor deposition of the alumina coating, an outer titanium nitride coating was applied also by chemical vapor deposition over the alumina coating. The heat treatment given Example VIII was one hour at 1750 °C in a 138 MPa (20 ksi) nitrogen atmosphere. The heat treatment for Example IX was one hour at 1750 °C in a 138 MPa (20 ksi) argon atmosphere. The titanium nitride coating was intact after the heat treatments and did not react with the sialon core.

### EXAMPLES X-XI

Examples X and XI were similar to Example I except the heat treating comprised one hour at 1650°C in 103 kPa (15 psi) nitrogen and one hour at 1650 °C in 138 MPa (20 ksi) nitrogen.

### Metal Cutting Tests

Metal cutting tests were conducted on Examples VIII to XI under the following conditions:

| | |
|---|---|
| Workpieces: | 1045 steel |
| Speed: | 5.08m/s (1000 sfm) |
| Feed: | 0.635 mm (.025 inches) per revolution |
| Depth of Cut: | 2.54 mm (0.1 inch) |
| Insert Style: | SNG-453 |

The results of the metal cutting tests are set forth in the following Table 4:

**TABLE 4**

| EXAMPLE | TOOL LIFE (MINUTES) | FAILURE MODE |
|---|---|---|
| VIII | 2.5 | NW, DOCN |
| IX | 2.4 | FW, DOCN |
| X | 4.4 | FW, CH |
| XI | 2.6 | FW, CR |
| I | 2.0 | FW, CR |
| KYON 2000 | <0.7 | FW, CR |
| KYON 2000 (as coated) | 1.0 | FW, CR |

The acronyms for the failure modes noted in Table 4 mean the following: FW = flank wear failure; CR = crater wear failure; CH = chipped; DOCN = depth of cut notch failure; and NW = nose wear failure.

The data in Table 4 establishes the substantial advantage of surface alloyed compositions according to this invention when used as cutting tool inserts. Examples VIII to XI all had tool life at least twice that of KYON 2000 and coated (but not surface alloyed) KYON 2000.

The applicants do not wish to be bound by any proposed theory but it now appears that the surface alloying according to this invention has the effect of increasing the Z value in the beta-prime-sialon phase near the surface. Recall the beta-prime-sialon has the general formula Si_{6-Z}Al_{Z}O_{Z}N_{8-Z}.

## Claims

1. A sialon ceramic material comprising a ceramic core consisting essentially of alpha-prime-sialon and/or beta-prime-sialon, and an intergranular phase, including a glass phase, characterized in that said sialon ceramic material has an alloyed surface layer with a substantially increased aluminum and oxygen content as compared with the core composition, with a value of Z=0.03 for beta-prime-sialon being disclaimed.

2. The material according to Claim 1, characterized in that the beta-prime-sialon phase in the core has a lower Z value than the beta-prime-sialon phase in the alloyed surface layer.

3. The material according to Claim 1, characterized in that the core consists essentially of beta-prime-sialon and 0.1 to 10 volume percent intergranular phase.

4. The material according to Claim 1, characterized in that the core consists essentially of up to 70 volume percent alpha-prime-sialon, 10 to 99.9 percent beta-prime-sialon and up to 10 percent of an intergranular phase.

5. The material according to Claim 1, characterized in that the sialons in the core have a volume ratio of alpha-prime-sialon to beta-prime-sialon between 5:95 and 95:5.

6. The material according to Claim 1, characterized in that the alloyed surface layer is approximately 2 to 10 µm thick.

7. The material according to Claim 1, characterized in that the porosity of the alloyed surface layer is equal to the porosity of the core.

8. The material according to Claim 1, characterized in that the beta-prime-sialon phase of the core material has a Z value greater than 0 and less than or equal to 2 and the beta-prime-sialon phase of the alloyed surface layer has a Z value greater than that of the core material and less than 4.

9. A sialon ceramic material comprising a ceramic core consisting essentially of alpha-prime-sialon and/or beta-prime-sialon, an intergranular phase, including a glass phase, and a refractory phase selected from the group consisting of refractory oxides, carbides, and nitrides of metals, and mixtures, compounds and solid solutions thereof, wherein said sialon ceramic material has an alloyed surface layer with a substantially increased aluminium and oxygen content as compared with the core composition, with a value of Z=0.03 for beta-prime-sialon being disclaimed.

10. The material according to Claim 1, characterized in that an alumina layer is disposed over the alloyed surface layer.

11. The material according to Claim 1 or 10, characterized in that a refractory outer layer is disposed over the alloyed surface layer, said refractory outer layer selected from the group carbides, nitrides, carbo-nitrides, oxides and mixtures thereof of vanadium, titanium, tantalum, niobium, hafnium or zirconium.

12. A method of alloying the surface of sialon materials to increase the Z value of the beta-prime-sialons near the surface comprising the steps of:
(a) preparing a sialon core composition, wherein the core composition consists essentially of alpha-prime-sialon, beta-prime-sialon and intergranular phases, including a glass phase,
(b) applying a coating of alumina to the surface of the core composition in a thickness of about 1 to 10 µm by chemical vapor deposition, and
(c) heat treating the coated composition at temperatures up to 1750°C and for times until at least a portion of the oxygen and aluminum of the alumina coating diffuses into the surface of the core composition.

13. A method of alloying the surface of sialon materials to increase the Z value of the beta-prime-sialons near the surface comprising the steps of:
(a) preparing a sialon core composition, wherein the core composition consists essentially of beta-prime-sialon and 0.1 to 10 volume percent intergranular phase, including a glass phase,
(b) applying a coating of alumina to the surface of the core composition in a thickness of about 1 to 10 µm by chemical vapor deposition, and
(c) heat treating the coated composition at temperatures up to 1750°C and for times until at least a portion of the oxygen and aluminum of the alumina coating diffuses into the surface of the core composition.

14. The method according to Claim 12, characterized in that the core composition consists essentially of up to 70 volume percent alpha-prime-sialon, 10 to 99.9 percent beta-prime-sialon and up to 10 percent of an intergranular phase.

15. The method according to Claim 12, characterized in that the sialons in the core composition have a volume ratio of alpha-prime-sialon to beta-prime-sialon between 5:95 and 95:5.

16. The method according to Claim 12, characterized in that the core further consists essentially of a refractory phase selected from the group consisting of refractory oxides, carbides, and nitrides of metals, and mixtures, compounds and solid solutions thereof.

17. The method according to Claim 12, characterized in that the chemical vapor deposition of the alumina coating is made at temperatures between 800 and 1100°C.

18. The method according to Claim 12, characterized in that the chemical vapor deposition of the alumina coating is made at temperatures between 950 and 1050°C.

19. The method according to Claim 12, characterized in that the thickness of the alumina coating applied by chemical vapor deposition is between 5 and 7 µm.

20. The method according to Claim 12, characterized in that the heat treating takes place at temperatures between 1500 and 1700°C, at pressures up to 207 MPa (30 ksi), and for periods between 15 minutes and 5 hours in a non-oxidizing atmosphere.

21. The method according to Claim 12, characterized in that the heat treating takes place at temperatures between 1300 and 1800°C, at pressures up to 207 MPa (30 ksi), and for periods between 15 minutes and 5 hours in a non-oxidizing atmosphere.

22. The method according to Claim 12, characterized in that the heat treating takes place under isostatic pressing conditions in an atmosphere selected from the gases nitrogen, helium, and argon and mixtures thereof.

23. The method according to Claim 12, characterized in that the heat treating is discontinued prior to the time all of the alumina has diffused into the surface of the core composition.

24. The method according to Claim 12, characterized in that an outer refractory coating is deposited by chemical vapor deposition over the alumina coating, said outer refractory coating selected from the group carbides, nitrides, carbonitrides, oxides and mixtures thereof of the vanadium, titanium, tantalum, niobium, hafnium or zirconium and said heat treating being discontinued prior to the time the outer refractory coating begins to substantially react with the alloyed surface of the core composition.

25. A cutting tool insert comprising a ceramic core consisting essentially of alpha-prime-sialon, beta-prime-sialon, and intergranular phases, including a glass phase, characterized in that said sialon ceramic material has an alloyed surface layer having a composition similar to the core but with a substantially increased aluminum and oxygen content as compared with the core composition.

26. A cutting tool insert comprising a ceramic core consisting essentially of beta-prime-sialon, and intergranular phases, including a glass phase, characterized in that said sialon ceramic material has an alloyed surface layer having a composition similar to the core but with a substantially increased aluminum and oxygen content as compared with the core composition.

## Patentansprüche

1. Keramisches Sialonmaterial mit einem keramischen Kern, der im wesentlichen aus α'-Sialon und/oder β'Sialon sowie aus einer intergranularen Phase, einschließlich einer Glasphase, besteht, dadurch gekennzeichnet, daß das keramische Sialonmaterial eine legierte Oberflächenschicht aufweist, die im Vergleich mit der Kernzusammensetzung einen wesentlich erhöhten Aluminium- und Sauerstoffgehalt besitzt, unter Ausschluß eines Wertes von Z = 0,03 für β'-Sialon.

2. Material nach Anspruch 1, dadurch gekennzeichnet, daß die β'-Sialonphase in dem Kern einen niedrigeren Z-Wert aufweist als die β'-Sialonphase in der legierten Oberflächenschicht.

3. Material nach Anspruch 1, dadurch gekennzeichnet, daß der Kern im wesentlichen aus β'-Sialon und 0,1 bis 10 Volumenprozent intergranularer Phase besteht.

4. Material nach Anspruch 1, dadurch gekennzeichnet, daß der Kern im wesentlichen aus bis zu 70 Volumenprozent α'-Sialon, 10 bis 99,9 Prozent β'-Sialon und bis zu 10 Prozent einer intergranularen Phase besteht.

5. Material nach Anspruch 1, dadurch gekennzeichnet, daß die Sialone in dem Kern ein Volumenverhältnis von α'-Sialon zu β'-Sialon zwischen 5:95 und 95:5 aufweisen.

6. Material nach Anspruch 1, dadurch gekennzeichnet, daß die legierte Oberflächenschicht etwa 2 bis 10 µm dick ist.

7. Material nach Anspruch 1, dadurch gekennzeichnet, daß die Porosität der legierten Oberflächenschicht gleich der Porosität des Kerns ist.

8. Material nach Anspruch 1, dadurch gekennzeichnet, daß die β'-Sialonphase des Kernmaterials einen Z-Wert von größer als 0 und weniger oder gleich 2 aufweist und die β'-Sialonphase der legierten Oberflächenschicht einen Z-Wert aufweist, der größer als der des Kernmaterials und kleiner als 4 ist.

9. Keramisches Sialonmaterial mit einem keramischen Kern, der im wesentlichen aus α'-Sialon und/oder β'Sialon sowie aus einer intergranularen Phase, einschließlich einer Glasphase, und einer feuerfesten Phase besteht, die aus der Gruppe bestehend aus feuerfesten Metalloxiden, -karbiden und -nitriden und deren Mischungen, Verbindungen und festen Lösungen ausgewählt ist, wobei das keramische Sialonmaterial eine legierte Oberflächenschicht aufweist, die im Vergleich mit der Kernzusammensetzung einen wesentlich erhöhten Aluminium- und Sauerstoffgehalt besitzt, unter Ausschluß eines Wertes von Z = 0,03 für β'-Sialon.

10. Material nach Anspruch 1, dadurch gekennzeichnet, daß eine Aluminiumoxidschicht über der legierten Oberflächenschicht angeordnet ist.

11. Material nach einem der Ansprüche 1 oder 10, dadurch gekennzeichnet, daß eine feuerfeste Außenschicht über der legierten Oberflächenschicht angeordnet ist, wobei die feuerfeste Außenschicht aus der Gruppe bestehend aus Karbiden, Nitriden, Karbonitriden, Oxiden und deren Mischungen von Vanadium, Titan, Tantal, Niob, Hafnium oder Zirkonium ausgewählt ist.

12. Verfahren zur Legierung der Oberfläche von Sialonmaterialien zur Erhöhung des Z-Wertes von β'-Sialonen nahe der Oberfläche, welches die folgenden Schritte umfaßt:
(a) eine Sialonkernzusammensetzung wird hergestellt, wobei die Kernzusammensetzung im wesentlichen aus α'-Sialon, β'-Sialon und intergranularen Phasen, einschließlich einer Glasphase, besteht;
(b) auf der Oberfläche der Kernzusammensetzung wird mittels chemischer Dampfabscheidung ein Überzug aus Aluminiumoxid in einer Dicke von etwa 1 bis 10 µm aufgebracht; und
(c) die beschichtete Zusammensetzung wird bei Temperaturen bis zu 1750°C so lange wärmebehandelt, bis mindestens ein Teil des Sauerstoffs und des Aluminiums des Aluminiumoxidüberzugs in die Oberfläche der Kernzusammensetzung diffundiert.

13. Verfahren zur Legierung der Oberfläche von Sialonmaterialien zur Erhöhung des Z-Wertes von β'-Sialonen nahe der Oberfläche, welches die folgenden Schritte umfaßt:
(a) eine Sialonkernzusammensetzung wird hergestellt, wobei die Kernzusammensetzung im wesentlichen aus β'-Sialon und 0,1 bis 10 Vol.-% intergranularer Phase, einschließlich einer Glasphase, besteht;
(b) auf der Oberfläche der Kernzusammensetzung wird mittels chemischer Dampfabscheidung ein Überzug aus Aluminiumoxid in einer Dicke von etwa 1 bis 10 µm aufgebracht; und
(c) die beschichtete Zusammensetzung wird bei Temperaturen bis zu 1750°C so lange wärmebehandelt, bis mindestens ein Teil des Sauerstoffs und des Aluminiums des Aluminiumoxidüberzugs in die Oberfläche der Kernzusammensetzung diffundiert.

14. Verfahren nach Anspruch 12, dadurch gekennzeichnet, daß die Kernzusammensetzung im wesentlichen aus bis zu 70 Volumenprozent α'-Sialon, 10 bis 99,9 Prozent β'-Sialon und bis zu 10 Prozent einer intergranularen Phase besteht.

15. Verfahren nach Anspruch 12, dadurch gekennzeichnet, daß die Sialone in der Kernzusammensetzung ein Volumenverhältnis von α'-Sialon zu β'-Sialon zwischen 5:95 und 95:5 aufweisen.

16. Verfahren nach Anspruch 12, dadurch gekennzeichnet, daß der Kern ferner im wesentlichen aus einer feuerfesten Phase besteht, die aus der Gruppe bestehend aus feuerfesten Metalloxiden, -karbiden und -nitriden und deren Mischungen, Verbindungen und festen Lösungen ausgewählt ist.

17. Verfahren nach Anspruch 12, dadurch gekennzeichnet, daß die chemische Dampfabscheidung des Aluminiumoxidüberzugs bei Temperaturen zwischen 800 und 1100°C durchgeführt wird.

18. Verfahren nach Anspruch 12, dadurch gekennzeichnet, daß die chemische Dampfabscheidung des Aluminiumoxidüberzugs bei Temperaturen zwischen 950 und 1050°C durchgeführt wird.

19. Verfahren nach Anspruch 12, dadurch gekennzeichnet, daß die Dicke des durch chemische Dampfabscheidung aufgebrachten Aluminiumoxidüberzugs zwischen 5 und 7 µm liegt.

20. Verfahren nach Anspruch 12, dadurch gekennzeichnet, daß die Wärmebehandlung bei Temperaturen zwischen 1500 und 1700°C, bei Drücken bis zu 207 MPa (30 ksi) und für die Dauer von zwischen 15 Minuten und 5 Stunden in einer nichtoxidierenden Atmosphäre durchgeführt wird.

21. Verfahren nach Anspruch 12, dadurch gekennzeichnet, daß die Wärmebehandlung bei Temperaturen zwischen 1300 und 1800°C, bei Drücken bis zu 207 MPa (30 ksi) und für die Dauer von zwischen 15 Minuten und 5 Stunden in einer nichtoxidierenden Atmosphäre durchgeführt wird.

22. Verfahren nach Anspruch 12, dadurch gekennzeichnet, daß die Wärmebehandlung in einer aus den Gasen Stickstoff, Helium und Argon und deren Mischungen ausgewählten Atmosphäre unter isostatischen Preßbedingungen durchgeführt wird.

23. Verfahren nach Anspruch 12, dadurch gekennzeichnet, daß die Wärmebehandlung vor dem Zeitpunkt abgebrochen wird, zu dem das ganze Aluminiumoxid in die Oberfläche der Kernzusammensetzung eindiffundiert ist.

24. Verfahren nach Anspruch 12, dadurch gekennzeichnet, daß ein äußerer feuerfester Überzug durch chemische Dampfabscheidung über dem Aluminiumoxidüberzug abgeschieden wird, wobei der äußere feuerfeste Überzug aus der Gruppe bestehend aus Karbiden, Nitriden, Karbonitriden, Oxiden und deren Mischungen des Vanadins, Titans, Tantals, Niobs, Hafniums oder Zirkoniums ausgewählt wird, und daß die Wärmebehandlung vor dem Zeitpunkt abgebrochen wird, zu dem der äußere feuerfeste Überzug wesentlich mit der legierten Oberfläche der Kernzusammensetzung zu reagieren beginnt.

25. Schneidwerkzeugeinsatz mit einem keramischen Kern, der im wesentlichen aus α'-Sialon, β'-Sialon und intergranularen Phasen, einschließlich einer Glasphase, besteht, dadurch gekennzeichnet, daß das keramische Sialonmaterial eine legierte Oberflächenschicht mit einer Zusammensetzung aufweist, die ähnlich der Zusammensetzung des Kerns ist, aber im Vergleich mit der Kernzusammensetzung einen wesentlich erhöhten Aluminium- und Sauerstoffgehalt aufweist.

26. Schneidwerkzeugeinsatz mit einem keramischen Kern, der im wesentlichen aus β'-Sialon und intergranularen Phasen, einschließlich einer Glasphase, besteht, dadurch gekennzeichnet, daß das keramische Sialonmaterial eine legierte Oberflächenschicht aufweist, die eine ähnliche Zusammensetzung wie der Kern, aber im Vergleich mit der Kernzusammensetzung einen wesentlich erhöhten Aluminium- und Sauerstoffgehalt besitzt.

## Revendications

1. Matériau céramique à base de sialon, comprenant un noyau en céramique composé essentiellement d'alpha-prime-sialon et/ou de béta-prime-sialon, et d'une phase intergranulaire, comprenant une phase vitreuse, caractérisé en ce que ledit matériau céramique à base de sialon présente une couche de surface en alliage à teneur en aluminium et en oxygène sensiblement augmentée, en comparaison avec la composition du noyau, à l'exception d'une valeur Z = 0,03 pour le béta-prime-sialon.

2. Matériau selon la revendication 1, caractérisé en ce que la phase béta-prime-sialon contenue dans le noyau présente une valeur Z inférieure à celle de la phase béta-prime-sialon contenue dans la couche de surface en alliage.

3. Matériau selon la revendication 1, caractérisé en ce que le noyau est composé essentiellement de bêta-prime-sialon et de 0,1 à 10 % en volume de phase intergranulaire.

4. Matériau selon la revendication 1, caractérisé en ce que le noyau est composé essentiellement jusqu'à 70 % en volume d'alpha-prime-sialon, 10 à 99,9 % de béta-prime-sialon, et jusqu'à 10 % d'une phase intergranulaire.

5. Matériau selon la revendication 1, caractérisé en ce que les sialons présents dans le noyau présentent un rapport de poids entre l'alpha-prime-sialon et le béta-prime-sialon compris entre 5:95 et 95:5.

6. Matériau selon la revendication 1, caractérisé en ce que la couche de surface en alliage présente une épaisseur d'à peu près 2 à 10 µm.

7. Matériau selon la revendication 1, caractérisé en ce que la porosité de la couche de surface en alliage est égale à la porosité du noyau.

8. Matériau selon la revendication 1, caractérisé en ce que la phase béta-prime-sialon du matériau de noyau présente une valeur Z supérieure à la valeur 0 et inférieure ou égale à la valeur 2, et la phase béta-prime-sialon de la couche de surface en alliage présente une valeur Z supérieure à celle du matériau de noyau et inférieure à la valeur 4.

9. Matériau céramique à base de sialon, comprenant un noyau en céramique composé essentiellement d'alpha-prime-sialon et/ou de béta-prime-sialon, d'une phase intergranulaire, comprenant une phase vitreuse et d'une phase réfractaire sélectionnée dans le groupe composé d'oxydes, de carbures et de nitrures de métaux réfractaires, et de leurs mélanges, composés et solutions solides, ledit matériau céramique à base de sialon présentant une couche de surface en alliage à teneur en aluminium et en oxygène sensiblement augmentée, en comparaison avec la composition du noyau, à l'exception d'une valeur Z = 0,03 pour le béta-prime-sialon.

10. Matériau selon la revendication 1, caractérisé en ce qu'une couche d'oxyde d'aluminium est disposée sur la couche de surface en alliage.

11. Matériau selon la revendication 1 ou 10, caractérisé en ce qu'une couche extérieure réfractaire est disposée sur la couche de surface en alliage, ladite couche extérieure réfractaire étant sélectionnée dans le groupe composé du groupe des carbures, nitrures, carbonitrures, oxydes et leurs mélanges, de vanadium, titane, tantale, niobium, hafnium ou zirconium.

12. Procédé d'alliage de la surface de matériaux à base de sialon, pour augmenter la valeur Z des béta-prime-sialons se trouvant près de la surface, comprenant les étapes de:
(a) préparation d'une composition de noyau à base de sialon, dans laquelle la composition du novau consiste essentiellement en de l'alpha-prime-sialon, du béta-prime-sialon et des phases intergranulaires, y comprise une phase vitreuse,
(b) application, à l'aide d'un dépôt en phase gazeuse par procédé chimique, d'un revêtement en oxyde a'aluminium sur la surface de la composition de noyau, selon une épaisseur d'à peu près 1 à 10 µm,
(c) traitement à la chaleur de la composition revêtue à des températures allant jusqu'à 1750°C, et pendant des périodes de temps durant jusqu'à ce qu'au moins une partie de l'oxygène et de l'aluminium du revêtement à base d'oxyde d'aluminium se diffuse dans la surface de la composition de noyau.

13. Procédé d'alliage de la surface de matériaux à base de sialon, pour augmenter la valeur Z des bêta-prime-sialons se trouvant près de la surface, comprenant les étapes de:
(a) préparation d'une composition de noyau à base de sialon, dans laquelle la composition du noyau consiste essentiellement en du béta-prime-sialon et 0,1 à 10 % en volume de phase intergranulaire, comprenant une phase vitreuse,
(b) application, à l'aide d'un dépot en phase gazeuse par procédé chimique, d'un revêtement en oxyde d'aluminium sur la surface de la composition de noyau, selon une épaisseur d'à peu près 1 à 10µm,
(c) traitement à la chaleur de la composition revêtue à des températures allant jusqu'à 1750 C°, et pendant des périodes de temps durant jusqu'à ce qu'au moins une partie de l'oxygène et de l'aluminium du revêtement à base d'oxyde d'aluminium se diffuse dans la surface de la composition de noyau.

14. Procédé selon la revendication 12, caractérisé en ce que la composition de novau consiste essentiellement en jusqu'à 70 % en volume d'alpha-prime-sialon, 10 à 99,9 % de béta-prime-sialon et jusqu'à 10 % d'une phase intergranulaire.

15. Procédé selon la revendication 12, caractérisé en ce que les sialons présents dans la composition de noyau présentent un rapport de volume entre l'alpha-prime-sialon et le béta-prime-sialon compris entre 5:95 et 95:5.

16. Procédé selon la revendication 12, caractérisé en ce que le noyau consiste en outre essentiellement en une phase réfractaire sélectionnée dans le groupe composé d'oxydes, carbures et nitrures de métaux réfractaires, et de leurs mélanges, composés et solutions solides.

17. Procédé selon la revendication 12, caractérisé en ce que le dépôt en phase gazeuse par procédé chimique du revêtement en oxyde d'aluminium est réalisée à des températures comprises entre 800 et 1100°C.

18. Procédé selon la revendication 12, caractérisé en ce que le dépôt en phase gazeuse par procédé chimique du revêtement en oxyde d'aluminium est réalisée à des températures comprises entre 950 et 1050°C

19. Procédé selon la revendication 12, caractérisé en ce que l'épaisseur du revêtement en oxyde d'aluminium appliqué par dépôt en phase gazeuse par procédé chimique est comprise entre 5 et 7 µm.

20. Procédé selon la revendication 12, caractérisé en ce que la traitement par la chaleur a lieu à des températures comprises entre 1500 et 1700°C, à des pressions allant jusqu'à 30 psi (207 MPa), et durant des périodes comprises entre 15 minutes et 5 heures, dans une atmosphère non-oxydante.

21. Procédé selon la revendication 12, caractérisé en ce que le traitement par la chaleur a lieu à des températures comprises entre 1300 et 1800°C, à des pressions allant jusqu'à 30 psi (207 MPa), et durant des périodes comprises entre 15 minutes et 5 heures, dans une atmosphère non-oxydante.

22. Procédé selon la revendication 12, caractérisé en ce que le traitement par la chaleur a lieu dans des conditions de pression isostatiques, dans une atmosphère sélectionnée parmi les gaz azote, hélium et argon, et leurs mélanges.

23. Procédé selon la revendication 12, caractérisé en ce que le traitement à la chaleur est arrêté avant le moment où la totalité de l'oxyde d'aluminium s'est diffusée dans la surface ce la composition de noyau.

24. Procédé selon la revendication 12, caractérisé en ce qu'un revêtement réfractaire extérieur est déposé par dépôt an phase gazeuse par procédé chimique, sur la revêtement en oxyde d'aluminium, ledit revêtement extérieur réfractaire étant sélectionné dans la groupe composé de carbures, nitrures, carbonitrures, oxydes et leurs mélanges, du vanadium, du titane, du tantale, de l'hafnium ou du zirconium, et ledit traitement par la chaleur étant arrêté avant le moment où le revêtement extérieur réfractaire commence à sensiblement réagir avec la surface en alliage de la composition de noyau.

25. Plaquette d'outil de coupe comprenant un noyau céramique consistant essentiellement en de l'alpha-prime-sialon, du béta-prime-sialon et des phases intergranulaires, y compris une phase vitreuse, caractérisé en ce que ledit matériau céramique à base de sialon présente une couche de surface en alliage dotée d'une composition analogue à celle du noyau, mais avec une teneur en aluminium et en oxygène sensiblement augmentée, en comparaison avec la composition du noyau.

26. Plaquette d'outil de coupe comprenant un noyau céramique consistant essentiellement an du béta-prime-sialon et des phases intergranulaires, comprenant une phase vitreuse, caractérisé en ce que ledit matériau céramique à base de sialon présente une couche de surface en alliage dotée d'une composition analogue à celle du noyau, mais avec une teneur en aluminium et en oxygène sensiblement augmentée, en comparaison avec la composition du noyau.
